Europäisches Patentamt

European Patent Office

Office européen des brevets

(11) Publication number: **0 057 336**
A2

# (12) EUROPEAN PATENT APPLICATION

(21) Application number: **81401737.2**

(22) Date of filing: **29.10.81**

(51) Int. Cl.³: **H 01 L 29/72,** H 01 L 29/52, H 01 L 29/06

(30) Priority: **29.01.81 US 229613**

(43) Date of publication of application: **11.08.82**
**Bulletin 82/32**

(84) Designated Contracting States: **AT DE FR GB NL SE**

(71) Applicant: **AMERICAN MICROSYSTEMS, INCORPORATED, 3800 Homestead Road, Santa Clara, CA 95051 (US)**

(72) Inventor: **Wollesen, Donald L., 11950 Vallejo Drive, Saratoga California 95070 (US)**

(74) Representative: **Corre, Jacques et al, Cabinet Regimbeau 26, Avenue Kléber, F-75116 Paris (FR)**

(54) **Bipolar transistor with base plate.**

(57) A bipolar transistor having improved beta and low leakage is formed. A base plate (48) is constructed directly above the region (17) between the base (26) and emitter (27) regions, and a potential is applied to the base plate which repels the majority carriers flowing between the emitter and the base contact regions. This causes the majority carrier flow between the base contact and emitter regions to occur deep within the base, thus allowing the collector potential to have a more pronounced effect in attracting majority carriers. Emitter-collector current flow, for any given emitter-base current, is increased over prior art devices, thus resulting in an improved beta.

5306

BIPOLAR TRANSISTOR WITH BASE PLATE

BACKGROUND OF THE INVENTION

Field of the Invention

This invention relates to a bipolar transistor device, and more particularly to a bipolar transistor device utilizing a base plate to reduce the effects of parasitic conduction paths during the operation of the device.

Description of the Prior Art

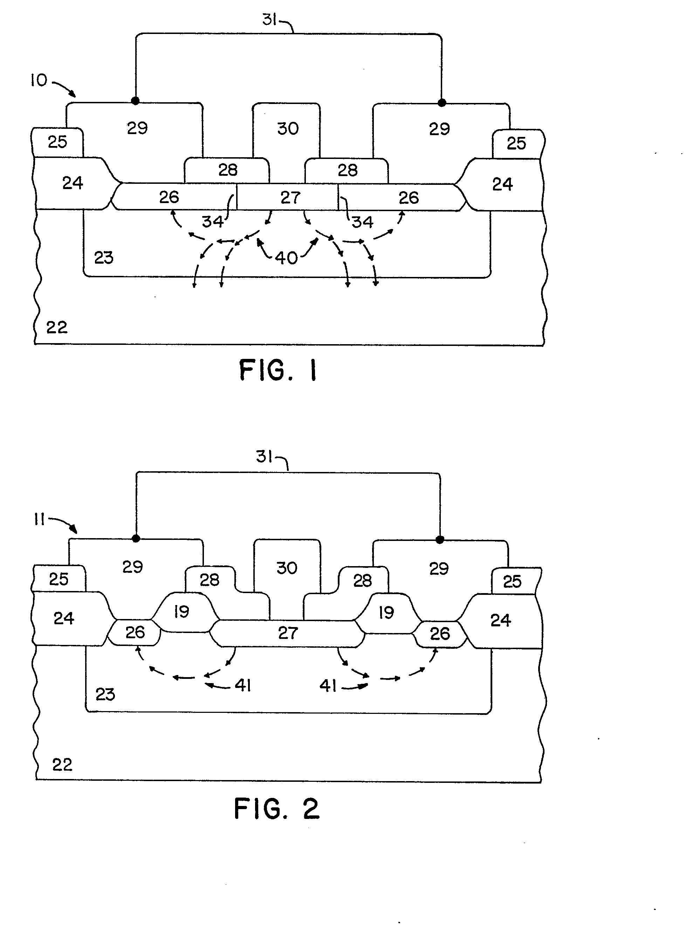

Bipolar transistors are well-known in the prior art. One such prior art bipolar transistor is shown in cross-sectional view in Figure 1. Bipolar transistor 10 is comprised of substrate 22, which is doped with an impurity resulting in substrate 22 having an N- conductivity type. P-well 23 is formed within substrate 22, and is doped with an impurity resulting in P-well 23 having P- type conductivity. Emitter region 27 is formed within P-well 23, and is formed to have an N+ conductivity type. Adjacent to emitter region 27 is formed base region 26, having a P+ conductivity type. Base contacts 29 are formed to allow external connection to base regions 26, and emitter contact 30 is formed to provide external connection to emitter region 27. Generally, base contacts 29 and emitter contact 30 are formed of a metallic substance, commonly aluminum, in order that external leads may be bonded thereto, thereby providing electrical connection to base region 26 and emitter region 27. Isolating base contacts 29 from emitter contact 30 are isolation regions 28. Field oxide regions 24, and isolation regions 25 are formed to isolate transistor 10 from adjacent devices which may be contained on the same semiconductor chip. Isolation regions are commonly comprised of silicon dioxide.

During the operation of NPN transistor 10 of Figure 1, substrate 22, which serves as the collector, is connected to a source of high positive potential. A drive signal is connected to base region 26 through lead 31 which is connected to base contact 29. Emitter region 27 is connected to a source of low potential via emitter contact 30. The flow of electrons from emitter region 27 to base region 26 is shown by the arrows of paths 40. It is desired to cause electrons to flow from emitter region 27 through P-well 23 near collector region 22, and then to base regions 26 as shown. With electrons flowing through P-well 23 adjacent to collector region 22, the high positive potential applied to collector region 22 will cause many of the electrons to flow out of P-well 23 and into collector 22. In this manner, the relatively small flow of electrons between emitter 27 to base 26 will cause a greater flow of electrons from emitter region 27 to collector region 22. In this fashion, transistor 10 may be utilized as a current amplification device.

In actual practice, the preferred base emitter current path is through PN junctions 34 located between emitter region 27 and base regions 26. PN junctions 34 are the preferred current paths at low currents, due to leakage, and at high current because PN junctions 34 have a lower IR drop than the path 40 from emitter region 27, through P-well 23, and to base regions 26. With a significant amount of base-emitter current flowing through PN junctions 34, fewer electrons flow from emitter region 27 along path 40 into P-well 23, and thus fewer electrons flow from emitter region 27 to collector region 22. Thus, for a given base-emitter current, collector-emitter current is reduced over that which may be obtained if base-emitter current did not flow across PN junctions 34, thus lowering the current gain or beta, of transistor 10.

A cross-sectional view of a second prior art bipolar transistor is shown in Figure 2. Regions are identically numbered with their functional counterparts of Figure 1. However, isolation regions 19 are used to separate emitter region 27 from base regions 26, thereby eliminating PN junctions 34 formed therebetween. In this manner, the problems associated with a leaky PN junction 34 of Figure 1 are eliminated. All electron flow between emitter 27 and base 26 must occur through P-well 23. However, most electron flow between emitter 27 and base 26 does not take place deep within P-well 23, near collector region 22, but rather takes place relatively distant from collector 22, such as along path 41. The current paths between emitter region 27 and base regions 26 within P-well 23 are as direct as possible, simply due to the fact that the shorter the path, the lower the resistance. Thus, for the transistor of Figure 2 as in the transistor of Figure 1, the current gain or beta is adversely affected by the fact that base-emitter current flow tends to take place through P-well 23 relatively distant from collector region 22.

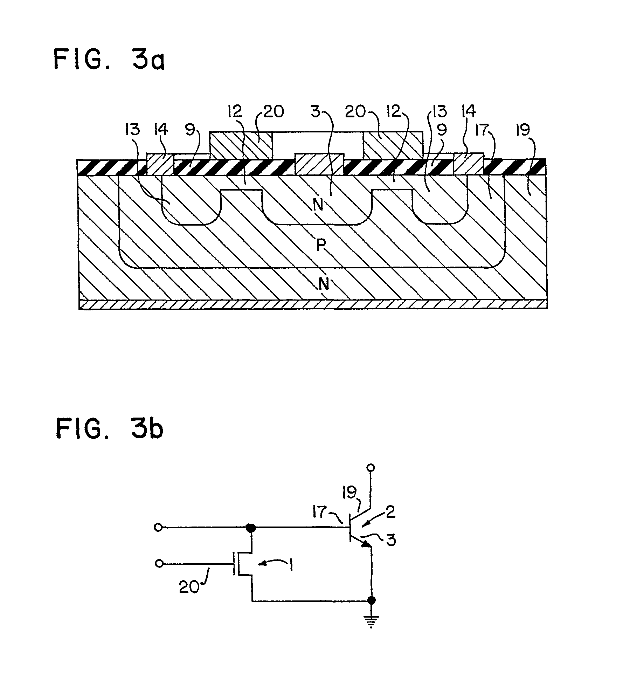

A prior art bipolar transistor which utilizes a surface control electrode in order to control the operating characteristics of the device is disclosed in U.S. Patent Application No. 3,243,669. A cross-sectional view of this structure is shown in Figure 3a; its schematic diagram is shown in Figure 3b. Emitter region 3, base region 17, and collector region 19 form a vertical NPN transistor. Control electrode 20 is located directly above channel region 12 of emitter region 3. Control electrode 20 is separated from channel region 12 by electrical isolation layer 9. Control electrode 20 serves as the gate of MOS transistor 1 of Figure 3b. Region 13 serves as the source of MOS transistor 20, and is connected to base 17 at base contact 14. Emitter region 3 also serves as the drain of MOS transistor 20. A positive voltage on control electrode 20 places more electrons in channel region 12, thus causing MOS transistor 1 to conduct, thus causing base 17 to be shorted to emitter 3, thus preventing bipolar transistor 2 from conducting. Placing a negative voltage on gate 20 causes MOS transistor 1 to turn off, thus allowing bipolar transistor 2 to operate in a normal manner. Thus, in this prior art circuit, a surface control electrode is utilized to form an MOS transistor which is able to reduce undesired leakage current in a bipolar transistor in its "off" or nonconducting state, while having no effect on the transistor operation in the "on" or conducting state.

## SUMMARY OF THE INVENTION

This invention overcomes difficulties in prior art bipolar transistors which adversely affect the current gain, or beta, due to base emitter current flow taking place relatively distant from the collector region, thereby attenuating the effect of the collector potential on the base-emitter current flow, thereby resulting in relatively low collector-emitter current flows for any given base-current flow. In contrast with prior art bipolar transistors which utilize a surface control electrode, this invention controls transistor operation during the conducting state, as opposed to prior art structures which control transistor operation during the nonconducting state.

## BRIEF DESCRIPTION OF THE DRAWINGS

Figure 1 is a cross-sectional view of a prior art bipolar transistor.

Figure 2 is a cross-sectional view of a second prior art bipolar transistor.

Figure 3a is a cross-sectional view of a prior art bipolar transistor utilizing a control electrode to reduce leakage currents.

Figure 3b is a schematic diagram of the structure of Figure 3a.

Figure 4 is a cross-sectional view of one embodiment of this invention.

Figure 5 is a cross-sectional view of a second embodiment of this invention.

DETAILED DESCRIPTION OF THE INVENTION

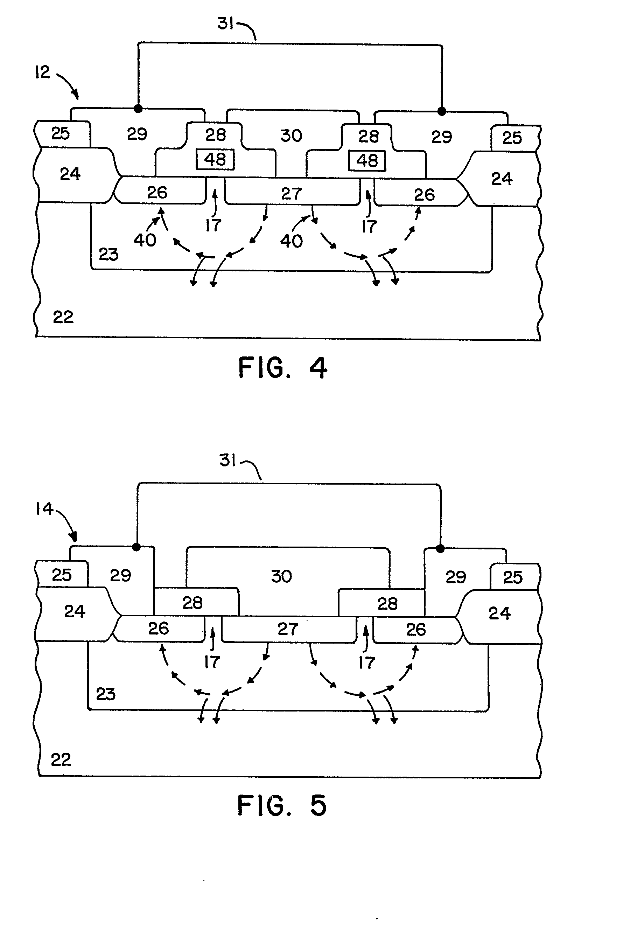

A cross-sectional view of one embodiment of this invention is shown in Figure 4. NPN transistor 12 is comprised of semiconductor substrate 22, which serves as the collector, P-well 23, which serves as the base, emitter region 27 doped to an N+ conductivity type, and base contact regions 26 doped to a P+ conductivity type. Emitter region 27 is not formed adjacent to base regions 26, therefore no PN junction is formed therebetween. Situated directly above regions 17 of P-well 23, which are located between emitter region 27 and base regions 26, are base plates 48. Base plates 48 are separated from P-well 23, emitter 27 and bases 26 by isolation region 28. Isolation regions 28 also serve to provide electrical insulation between emitter contact 30 and base contacts 29. Base plates 48 may be formed of a metal such as aluminum, polycrystalline silicon, or any other suitable conductor. Field oxide regions 24 and isolation regions 25 are used to isolate transistor 12 from other devices which may be contained on the same semiconductor chip.

The transistor of Figure 4 is fabricated by utilizing standard masking techniques, and the following process. The substrate is a 100 silicon wafer having an N conductivity type of (for example) approximately 3-5 ohm-cm. Similarly, the substrate may be formed of other semiconductor material and of semiconductor material having crystal orientation other than 100 . P-well 23, which serves as the base, is formed by well-known techniques, and has a doping of approximately $1 \times 10^{16}$ atoms/cc. A highly N+ doped layer of silicon dioxide containing approximately 7% phosphorus is formed above the to-be-formed emitter 27 to a thickness of approximately 4000 angstroms, utilizing well-known techniques. This silicon dioxide layer is covered with a layer of approximately 2000 angstroms of undoped silicon dioxide. The total thickness of these layers is within the range of approximately 5400 to 6600 angstroms. The base contact region 26 is formed by subjecting the to-be-formed anode region, which is not masked by either silicon dioxide layer, to a P+ Boron predeposition utilizing $BBr_3$ as a Boron source. This is accomplished by a 5 minute push (the time it takes to insert a boat of wafers into a furnace), followed by an 8 minute soak, to allow the wafers to reach a uniform temperature, followed by a 5 minute source (where the wafers are subjected to the $BBr_3$ Boron source), and a 3 minute pull (removal of boat from the furnace). The furnace temperature is maintained at approximately 1025°C during the Boron predeposition. The Boron predeposition results in a V/I characteristics of approximately 7 $\pm$ 1/2 ohm. Other doping methods commonly known to those skilled in the art may be used for these N+ and P+ doping regions.

The silicon dioxide is then removed by standard etch methods. The emitter 27 and base contact 26 dopants are then diffused to the desired depth of approximately 1.2 microns by a reoxidation of emitter 27 and base contact region 26 by subjecting the wafer to dry $O_2$ at approximately 950°C utilizing a 5 minute push, 40 minute soak and 5 minute pull. This results in a silicon dioxide layer of approximately 400 $\pm$ 75 angstroms.

Contacts 29 and 30 provide a metallic (preferably aluminum) interconnection to regions 26 and 27, respectively, thereby allowing simple and efficient connection to external devices.

The operation of the bipolar transistor of the embodiment of this invention depicted in Figure 4 is as follows. Collector region 22 is connected to a source of high positive potential. Emitter region 27 is connected to a source of low potential, via emitter contact 30. A bias signal is applied to base regions 26 through base contact 29 from base lead 31. Base plate 48 is connected to a source of electric potential of a polarity which will repel the majority carriers which will flow between emitter region 27 and base region 26. Thus, for the NPN transistor of Figure 4, a negative potential would be applied to base plates 48; the base plates 48 may be normally connected directly to emitter lead 30 or, alternatively, base lead 31. Conversely, for a PNP transistor, a positive potential would be applied to base plates 40.

With a positive signal applied to base region 26, electrons flow from emitter region 27, through P-well 23, to base region 26. Due to the negative potential applied to base plate 48, the electron path 40 is located deep within P-well 23, near collector region 22. Electrons do not flow between emitter region 27 and base region 26 near base plate 48, because they are repelled by the negative potential on base plate 48, and the electrons are forced deep into P-well 23, as shown. With electron path 40 located deep within P-well 23, the positive potential applied to collector region 22 causes a large portion of the electrons contained within path 40 to be diverted, and flow from emitter 27 to collector 22. In this manner, the current gain, or beta, of a bipolar transistor constructed in accordance with this invention is increased over prior art transistors, due to the fact that the base plate causes a greater percentage of the base emitter current flow to take place in the vicinity of collector region 22, thereby increasing the effectiveness of the positive potential on collector region 22 to attract electrons flowing from emitter region 27 along path 40.

In a preferred embodiment of this invention, base plate 48 is electrically connected to emitter region 27. This connection allows base plate 48 to maintain a correct bias, and eliminates the need for a separate bias generating scheme. Furthermore, circuit size is reduced by eliminating the need for means for external electrical contact to the base plate.

A cross sectional view of a second transistor constructed in accordance with this invention is shown in Figure 5. The transistor of Figure 5 is very similar to the first preferred embodiment shown in Figure 3, with similar regions labelled with similar numerals. Starting material and fabrication processes are the same as those for the transistor of Figure 4. The transistor of Figure 5 utilizes emitter contact metal 30 as the base plate. Note that emitter contact 30, which is typically comprised of metallic substance, often aluminum, is formed to serve the function of the base plate. In addition to emitter contact 30 providing electrical connection to emitter region 27, it is also formed directly above regions 17 located within P-well 23 between emitter region 27 and base regions 26. Isolation regions 28 insulate emitter contact 30 from P-well 23 and base regions 26. During the operation of the NPN transistor 14 of Figure 5, current is caused to flow from emitter region 27 to base region 26 through P-well 23. With emitter contact region 30 serving as a base plate above region 17, majority carriers flowing between emitter region 27 and base regions 26 are repelled by emitter contact 30 serving as the base plate. This causes the base emitter current flow to occur deep within P-well 23, along paths 40. Since paths 40 are located near collector region 22, collector region 22 is able to attract a greater share of current carriers contained within path 40 than would be possible if path 40 was formed without the use of a base plate. Thus, for a given base-emitter current flow, the emitter-collector current is increased over prior art devices, thus resulting in improved current gain (beta) over prior art devices.

I claim:

1. A bipolar transistor comprising:

a collector region of semiconductor material doped to a first conductivity type;

a base region located within said collector region doped to a conductivity type opposite the conductivity type of said collector region;

an emitter region located within said base region, said emitter region being doped to said first conductivity type;

a base contact region located within said base region and apart from said emitter region, said base contact region being doped to said opposite conductivity type;

means for controlling the potential in the portion of said base region adjacent said emitter region whereby the current gain of said bipolar transistor is enhanced, said means for controlling being located above and between, and insulated from, said base contact and emitter regions.

2. Structure as in Claim 1 wherein said means for controlling is connected to an electric potential of a polarity which will repel majority carriers which flow between said emitter region to said base contact region forward bias.

3. Structure as in Claim 2 wherein said electric potential is of sufficient magnitude to repel said majority carriers deep within said base region, and thus near said collector region.

4. Structure as in Claim 1 wherein said means for controlling is connected to said emitter region.

5. Structure as in Claim 4 wherein said means for controlling forms part of a conductive emitter contact.

6. The method for forming a bipolar transistor comprising the steps of:

forming a base region within a collector region doped to a conductivity type opposite the conductivity type of said collector region;

forming an emitter region within said base region, said emitter region being doped to the same conductivity type as said collector region;

forming a base contact region within said base region and apart from said emitter region, said base contact region being doped to said opposite conductivity type;

forming means for controlling the potential in the portion of said base region adjacent said emitter region whereby the current gain of said bipolar transistor is enhanced, said means for controlling being formed above and between, and insulated from, said base contact and emitter regions.

7. Method as in Claim 6 wherein said means for controlling is connected to an electric potential of a polarity which will repel majority carriers which flow between said emitter region to said base contact region forward bias.

8. Method as in Claim 7 wherein said electric potential is of sufficient magnitude to repel said majority carriers deep within said base region, and thus near said collector region.

9.   Method as in Claim 6 wherein said means for controlling is connected to said emitter region.

10.   Method as in Claim 9 wherein said means for controlling forms part of a conductive emitter contact.

1/3

FIG. 1

FIG. 2

FIG. 3a

FIG. 3b

3/3

FIG. 4

FIG. 5